# EUROPEAN PATENT APPLICATION

(11) **EP 4 376 066 A1**
(43) Date of publication of application: **29.05.2024**
(21) Application number: 23204015.4
(22) Date of filing: 17.10.2023
(51) Int. Cl.: H01L 21/8234, H01L 27/02, H01L 27/088

(54) **SEMICONDUCTOR DEVICE INCLUDING COMMON BODY BIAS REGION**

(30) Priority: 28.11.2022 KR 20220161917; 25.07.2023 US 202318226037
(71) Applicant: Samsung Electronics Co., Ltd., Suwon-si, Gyeonggi-do 16677 (KR)
(72) Inventor: YU, Changyeon, 16677 Suwon-si (KR); KWAK, Pansuk, 16677 Suwon-si (KR)
(74) Representative: Marks & Clerk LLP

(57) **Abstract**

A semiconductor device includes a substrate (PSUB), a P-well region (PW), a first N-type metal oxide semiconductor (NMOS) transistor (NM1) provided in the P-well region, a second NMOS transistor (NM2) provided on the substrate, and a common body bias region (JCB) provided between the first NMOS transistor and the second NMOS transistor and contacting both the P-well region and the substrate.

## Description

### TECHNICAL FIELD

The present disclosure relates to a semiconductor device, and more particularly, to a semiconductor device including a common body bias region.

### BACKGROUND

A semiconductor device may provide various functions by utilizing an electrical characteristic of a semiconductor element. The semiconductor device may be implemented by forming various semiconductor patterns on a silicon substrate such that various functions are provided. As the degree of integration of semiconductor devices increases, the area available for forming semiconductor elements decreases.

### SUMMARY

One or more example embodiments provide a semiconductor device with a reduced area.

According to an aspect of one or more example embodiments, a semiconductor device includes: a substrate including a P-well region; a first N-type metal oxide semiconductor (NMOS) transistor provided above the P-well region; a second NMOS transistor provided on the substrate; and a common body bias region provided between the first NMOS transistor and the second NMOS transistor, and contacting both the P-well region and the substrate, wherein the common body bias region is configured to provide a bias voltage to the first NMOS transistor and the second NMOS transistor.

According to an aspect of one or more example embodiments, a semiconductor device includes: a substrate including: a P-well region including: a first active region; a second active region; and a first gate provided between the first active region and the second active region; a substrate region including: a third active region; a fourth active region; and a second gate provided between the third active region and the fourth active region; and a common body bias region contacting the substrate region and the P-well region, wherein the common body bias region is configured to provide a bias voltage to at least one of the first active region and second active region, and to at least one of the third active region and the fourth active region.

According to a further aspect of one or more example embodiments, a semiconductor device includes: a substrate having a first conductivity type; a well region having the first conductivity type and provided on the substrate; a first MOS transistor provided in the well region and including a first active region having a second conductivity type; a second MOS transistor provided on the substrate and including a second active region having the second conductivity type; and a common body bias region provided between the first MOS transistor and the second MOS transistor and contacting both the well region and the substrate, wherein the first MOS transistor and the second MOS transistor are electrically connected to the common body bias region, and wherein the common body bias region is configured to provide a bias voltage to the first MOS transistor and the second MOS transistor.

At least some of the above and other features of the invention are set out in the claims.

### BRIEF DESCRIPTION OF THE DRAWINGS

The above and/or other aspects and features of the present disclosure will be more apparent from the following description of example embodiments taken in conjunction with the accompanying drawings, in which:
FIG. 1 is a circuit diagram indicating a semiconductor device;
FIG. 2 is a plan view of semiconductor device of FIG. 1;
FIG. 3 is a cross-sectional view of a semiconductor device taken along line A-A' of FIG. 2;
FIG. 4 is a circuit diagram indicating a semiconductor device according to one or more example embodiments;
FIG. 5 is a plan view of a semiconductor device according to one or more example embodiments;
FIG. 6 is a cross-sectional view of a semiconductor device taken along line B-B' of FIG. 5 according to one or more example embodiments;
FIG. 7 is a cross-sectional view of a semiconductor device according to one or more example embodiments;
FIG. 8 is a cross-sectional view of a semiconductor device according to one or more example embodiments;
FIG. 9 is a cross-sectional view of a semiconductor device according to one or more example embodiments;
FIG. 10 is a cross-sectional view of a semiconductor device according to one or more example embodiments;
FIG. 11 is a cross-sectional view of a semiconductor device according to one or more example embodiments;
FIG. 12 is a cross-sectional view of a semiconductor device according to one or more example embodiments;
FIG. 13 is a plan view illustrating a guard band of a semiconductor device according to one or more example embodiments;
FIG. 14 is a block diagram indicating a memory device to which a semiconductor device of the present disclosure is applied according to one or more example embodiments;
FIG. 15 is a diagram illustrating a portion of a page buffer circuit of FIG. 14 according to one or more example embodiments; and
FIG. 16 is a cross-sectional view of a semiconductor device according to one or more example embodiments.

### DETAILED DESCRIPTION

Hereinafter, example embodiments will be described in detail with reference to the accompanying drawings. The same reference numerals are used for the same components in the drawings, and duplicate descriptions thereof are omitted.

Below, for brevity of drawing and convenience of description, the terms "length", "width", "depth", "height", etc. are used to describe one or more example embodiments. Unless otherwise defined in the specification, a first direction and a second direction represent directions defining a plane that is parallel to a semiconductor substrate, and a third direction represents a direction defining a direction perpendicular to the semiconductor substrate. According to one or more example embodiments, the length may correspond to the first direction, the width may correspond to the second direction, and the depth or the height may correspond to the third direction. However, the terms are to describe one or more example embodiments of the present disclosure easily, and it may be understood that one or more example embodiments are not limited by the aforementioned terms.

Below, some reference signs may be duplicated and used. The duplicated reference signs may refer to the same components in each of one or more example embodiments. Alternatively, the duplicated reference signs may refer to different components in a different one or more example embodiments. Accordingly, a component to which each reference sign refers should be understood in the context of respective one or more example embodiments or combined example embodiments.

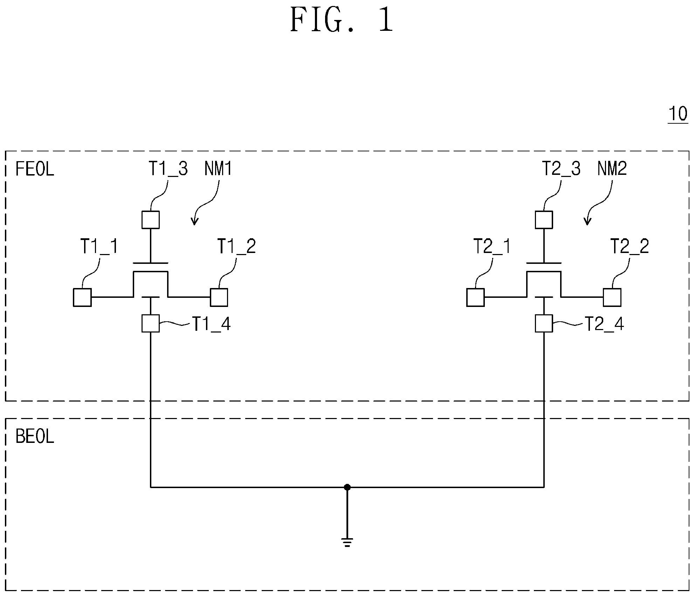

FIG. 1 is a circuit diagram indicating a semiconductor device. Referring to one or more example embodiments of FIG. 1, a semiconductor device 10 may include a first N-type metal oxide semiconductor (NMOS) transistor NM1 and a second NMOS transistor NM2.

The first NMOS transistor NM1 may include a first terminal T1_1, a second terminal T1_2, and a third terminal T1_3. The second NMOS transistor NM2 may include a first terminal T2_1, a second terminal T2_2, and a third terminal T2_3.

The first terminal T1_1 of the first NMOS transistor NM1 may be a source terminal or a drain terminal, the second terminal T1_2 of the first NMOS transistor NM1 may be a drain terminal or a source terminal, and the third terminal T1_3 of the first NMOS transistor NM1 may be a gate terminal. The first terminal T2_1 of the second NMOS transistor NM2 may be a source terminal or a drain terminal, the second terminal T2_2 of the second NMOS transistor NM2 may be a drain terminal or a source terminal, and the third terminal T2_3 of the second NMOS transistor NM2 may be a gate terminal.

The first NMOS transistor NM1 may operate in response to an electrical signal provided through the third terminal T1_3 of the first NMOS transistor NM1, and the second NMOS transistor NM2 may operate in response to an electrical signal provided through the third terminal T2_3 of the second NMOS transistor NM2.

The first NMOS transistor NM1 may further include a fourth terminal T1_4, and the second NMOS transistor NM2 may further include a fourth terminal T2_4. A body bias voltage may be provided through the fourth terminal T1_4 of the first NMOS transistor NM1. Also, a body bias voltage may be provided through the fourth terminal T2_4 of the second NMOS transistor NM2.

A characteristic of the first NMOS transistor NM1 may be different from a characteristic of the second NMOS transistor NM2. As an example, according to one or more example embodiments the first NMOS transistor NM1 may be a low-voltage transistor whose gate terminal is supplied with a low voltage, and the second NMOS transistor NM2 may be a high-voltage transistor whose gate terminal is supplied with a high voltage.

According to one or more example embodiments, the first NMOS transistor NM1 and the second NMOS transistor NM2 may be formed on a substrate through the front end of line (FEOL) process of the semiconductor device 10. According to one or more example embodiments, the fourth terminal T1_4 of the first NMOS transistor NM1 and the fourth terminal T2_4 of the second NMOS transistor NM2 may be connected to a wire providing a ground voltage, through the back end of line (BEOL) process. That is, the fourth terminal T1_4 of the first NMOS transistor NM1 and the fourth terminal T2_4 of the second NMOS transistor NM2 may be formed independently of each other.

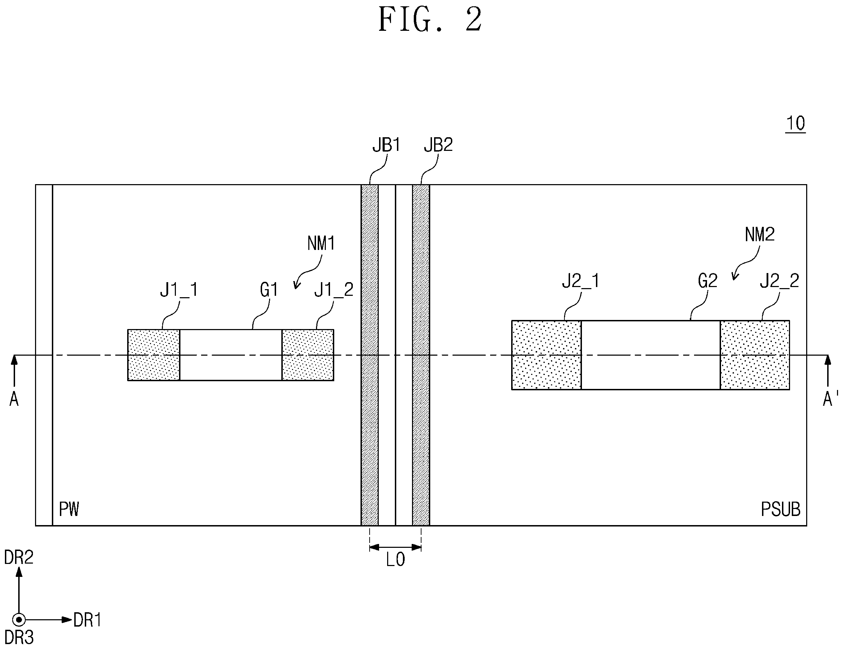

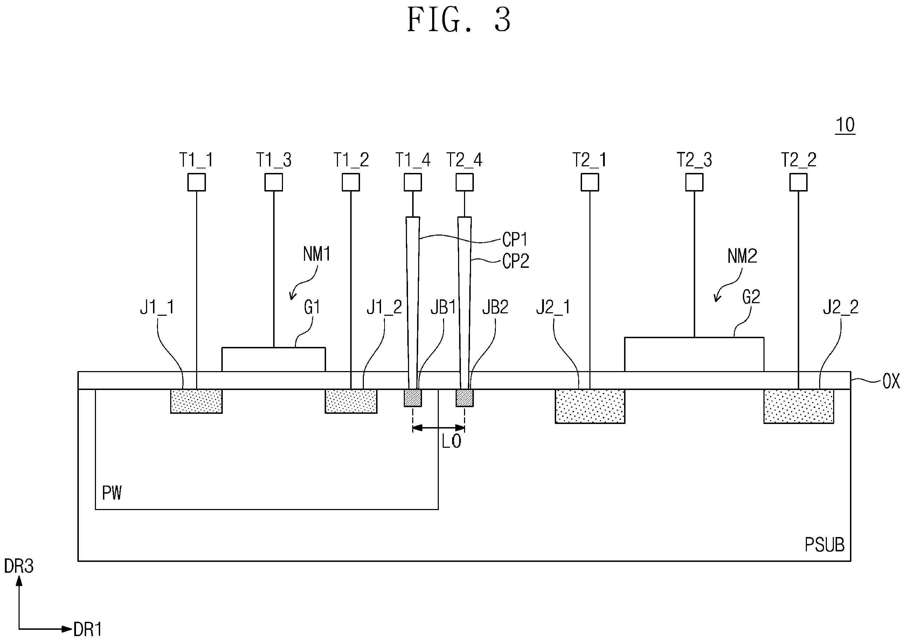

FIG. 2 is a plan view of semiconductor device of FIG. 1. FIG. 3 is a cross-sectional view of a semiconductor device taken along line A-A' of FIG. 2. Referring to FIGS. 2 and 3, the semiconductor device 10 may include the first NMOS transistor NM1 and the second NMOS transistor NM2. The first NMOS transistor NM1 and the second NMOS transistor NM2 may be formed on a P-type substrate PSUB. The P-type substrate PSUB may be provided on a plane defined by a first direction DR1 and a second direction DR2.

The first NMOS transistor NM1 may include a first active region J1_1, a second active region J1_2, and a first gate G1. The first active region J1_1 and the second active region J1_2 of the first NMOS transistor NM1 may be regions doped with N-type impurities. The first active region J1_1 and the second active region J1_2 of the first NMOS transistor NM1 may be formed in a P-well region PW of the P-type substrate PSUB. The P-well region PW may be a region doped with P-type impurities whose concentration is relatively high compared to the P-type substrate PSUB. An oxide layer OX may be formed on the first active region J1_1 and the second active region J1_2 of the first NMOS transistor NM1. The first gate G1 may be formed on the oxide layer OX. In the first NMOS transistor NM1, the first active region J1_1 may be electrically connected to the first terminal T1_1, the second active region J1_2 may be electrically connected to the second terminal T1_2, and the first gate G1 may be electrically connected to the third terminal T1_3. In the first NMOS transistor NM1, each of the electrical connection of the first active region J1_1 and the first terminal T1_1, the electrical connection of the second active region J1_2 and the second terminal T1_2, and the electrical connection of the first gate G1 and the third terminal T1_3, may be implemented through a contact plug formed along a third direction DR3.

The second NMOS transistor NM2 may include a first active region J2_1, a second active region J2_2, and a second gate G2. The first active region J2_1 and the second active region J2_2 of the second NMOS transistor NM2 may be regions doped with N-type impurities. The first active region J2_1 and the second active region J2_2 of the second NMOS transistor NM2 may be formed on the P-type substrate PSUB. The oxide layer OX may be formed on the first active region J2_1 and the second active region J2_2 of the second NMOS transistor NM2. The second gate G2 may be formed on the oxide layer OX.

In the second NMOS transistor NM2, the first active region J2_1 may be electrically connected to the first terminal T2_1, the second active region J2_2 may be electrically connected to the second terminal T2_2, and the second gate G2 may be electrically connected to the third terminal T2_3. In the second NMOS transistor NM2, each of the electrical connection of the first active region J2_1 and the first terminal T2_1, the electrical connection of the second active region J2_2 and the second terminal T2_2, and the electrical connection of the second gate G2 and the third terminal T2_3, may be implemented through a contact plug formed along the third direction DR3.

According to one or more example embodiments, a first body bias region JB1 may be formed in the P-well region PW. The first body bias region JB1 may be electrically connected to the fourth terminal T1_4 of the first NMOS transistor NM1 through a first body bias contact plug CP1 formed on the first body bias region JB1. The body bias voltage may be applied to the first body bias contact plug CP1 and may be provided to the first NMOS transistor NM1 through the first body bias region JB1.

A second body bias region JB2 may be formed in the P-type substrate PSUB. The second body bias region JB2 may be electrically connected to the fourth terminal T2_4 of the second NMOS transistor NM2 through a second body bias contact plug CP2 formed on the second body bias region JB2. The body bias voltage may be applied to the second body bias contact plug CP2 and may be provided to the second NMOS transistor NM2 through the second body bias region JB2.

Because the first body bias contact plug CP1 and the second body bias contact plug CP2 are respectively formed on the first body bias region JB1 and the second body bias region JB2, there may be formed separate metal lines for transferring the body bias voltage, thereby causing an increase in wiring complexity. In addition, because the first body bias region JB1 and the second body bias region JB2 are spaced apart from each other as much as a 0-th distance L0, the area of the semiconductor device 10 may increase.

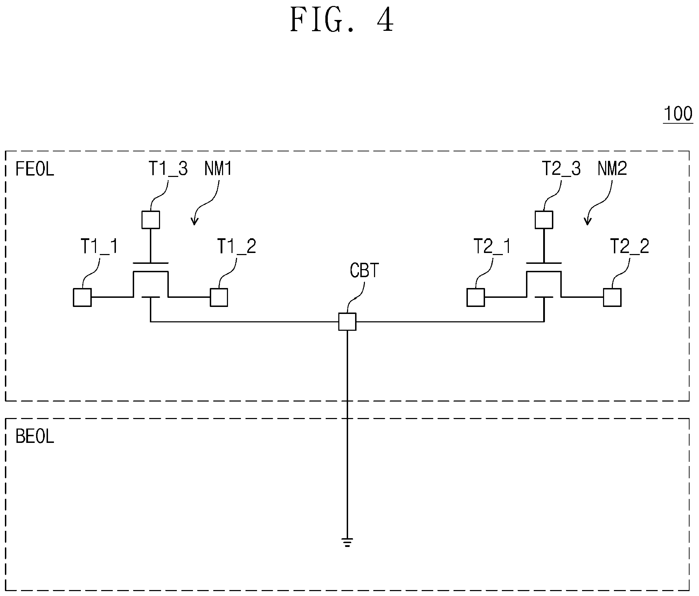

FIG. 4 is a circuit diagram indicating a semiconductor device according to one or more example embodiments. Referring to FIG. 4, a semiconductor device 100 may include the first NMOS transistor NM1 and the second NMOS transistor NM2. The first NMOS transistor NM1 may include the first terminal T1_1, the second terminal T1_2, and the third terminal T1_3. The second NMOS transistor NM2 may include the first terminal T2_1, the second terminal T2_2, and the third terminal T2_3.

Similar to the above description, a characteristic of the first NMOS transistor NM1 may be different from a characteristic of the second NMOS transistor NM2. As an example, according to one or more example embodiments, the first NMOS transistor NM1 may be a low-voltage transistor whose gate terminal is supplied with a low voltage, and the second NMOS transistor NM2 may be a high-voltage transistor whose gate terminal is supplied with a high voltage.

The semiconductor device 100 may further include a common body bias terminal CBT. The first NMOS transistor NM1 and the second NMOS transistor NM2 may share one common body bias terminal CBT. The body bias voltage may be simultaneously provided to both the first NMOS transistor NM1 and the second NMOS transistor NM2 through one common body bias terminal CBT.

The first NMOS transistor NM1, the second NMOS transistor NM2, and the common body bias terminal CBT may be formed on a substrate through the FEOL process of the semiconductor device 100. The common body bias terminal CBT may be connected to a wire providing the ground voltage, through the BEOL process. The body bias voltage may be provided to the first NMOS transistor NM1 and the second NMOS transistor NM2 through one terminal, that is, through the common body bias terminal CBT.

In one or more example embodiments, unlike the semiconductor device 10 of FIG. 1 where the fourth terminal T1_4 of the first NMOS transistor NM1 and the fourth terminal T2_4 of the second NMOS transistor NM2 are disposed, the semiconductor device 100 of FIG. 4 may be implemented such that the first NMOS transistor NM1 and the second NMOS transistor NM2 share one common body bias terminal CBT. As such, the total area of the semiconductor device 100 may decrease.

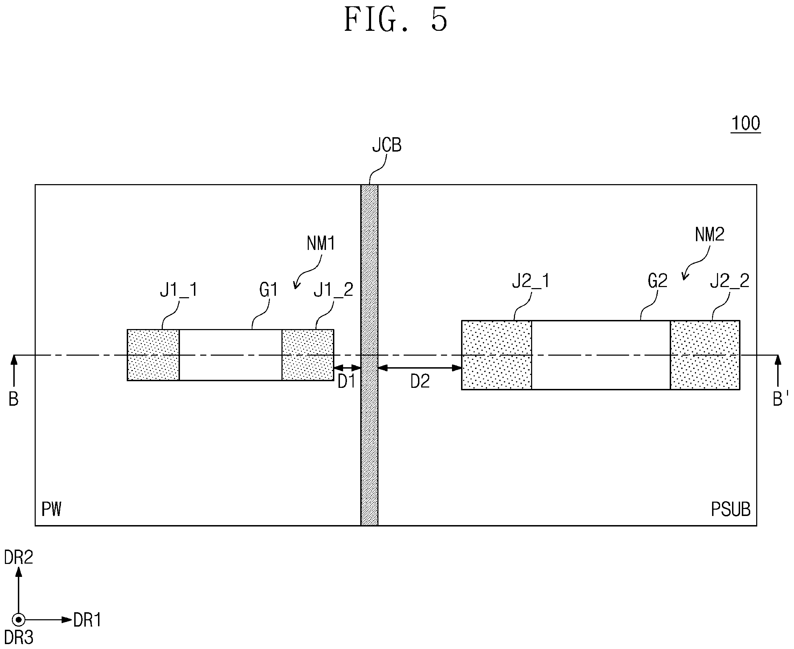

Below, one or more example embodiments in which the first NMOS transistor NM1 and the second NMOS transistor NM2 share one common body bias region will be described with reference to FIGS. 5, 6, 7, 8, 9, 10, 11 and 12. To describe one or more example embodiments clearly and briefly, the same reference numerals/signs may be attached to some components, and the detailed description for the same components may be omitted. However, one or more example embodiments are not limited thereto. For example, even though the same reference numerals/signs are used in different one or more example embodiments, components to which the same reference numerals/signs refer may provide similar functions but may provide partially different characteristics depending on respective one or more example embodiments. Some different characteristics described above may be understood in consideration of one or more example embodiments.

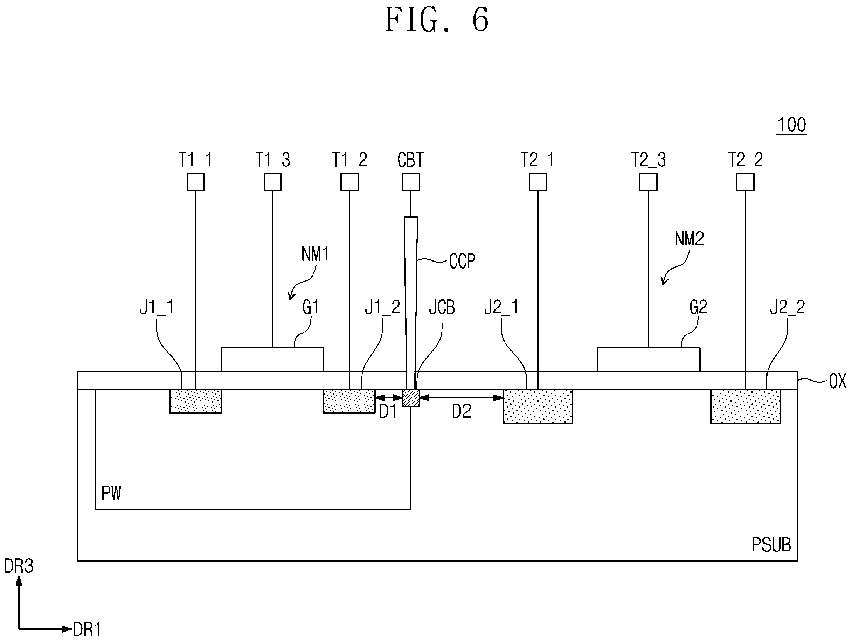

FIG. 5 is a plan view of a semiconductor device according to one or more example embodiments. FIG. 6 is a cross-sectional view of a semiconductor device taken along line B-B' of FIG. 5 according to one or more example embodiments. Referring to FIGS. 5 and 6, the semiconductor device 100 may include the first NMOS transistor NM1, the second NMOS transistor NM2, and one common body bias region JCB.

The first NMOS transistor NM1 may include the first active region J1_1, the second active region J1_2, and the first gate G1. The first active region J1_1 and the second active region J1_2 of the first NMOS transistor NM1 may be regions doped with N-type impurities. The first active region J1_1 and the second active region J1_2 of the first NMOS transistor NM1 may be formed in a P-well region PW of the P-type substrate PSUB. The P-well region PW may be a region doped with P-type impurities whose concentration is relatively high compared to the P-type substrate PSUB. The oxide layer OX may be formed on the first active region J1_1 and the second active region J1_2 of the first NMOS transistor NM1. The first gate G1 may be formed on the oxide layer OX.

In the first NMOS transistor NM1, the first active region J1_1 may be electrically connected to the first terminal T1_1, the second active region J1_2 may be electrically connected to the second terminal T1_2, and the first gate G1 may be electrically connected to the third terminal T1_3. In the first NMOS transistor NM1, each of the electrical connection of the first active region J1_1 and the first terminal T1_1, the electrical connection of the second active region J1_2 and the second terminal T1_2, and the electrical connection of the first gate G1 and the third terminal T1_3, may be implemented through a contact plug formed along a third direction DR3.

The second NMOS transistor NM2 may include the first active region J2_1, the second active region J2_2, and the second gate G2. The first active region J2_1 and the second active region J2_2 of the second NMOS transistor NM2 may be regions doped with N-type impurities. The first active region J2_1 and the second active region J2_2 of the second NMOS transistor NM2 may be formed on the P-type substrate PSUB. The oxide layer OX may be formed on the first active region J2_1 and the second active region J2_2 of the second NMOS transistor NM2. The second gate G2 may be formed on the oxide layer OX.

In the second NMOS transistor NM2, the first active region J2_1 may be electrically connected to the first terminal T2_1, the second active region J2_2 may be electrically connected to the second terminal T2_2, and the second gate G2 may be electrically connected to the third terminal T2_3. In the second NMOS transistor NM2, each of the electrical connection of the first active region J2_1 and the first terminal T2_1, the electrical connection of the second active region J2_2 and the second terminal T2_2, and the electrical connection of the second gate G2 and the third terminal T2_3, may be implemented through a contact plug formed along the third direction DR3.

According to one or more example embodiments, the common body bias region JCB may be disposed between the first NMOS transistor NM1 and the second NMOS transistor NM2 and may be formed to contact both the P-well region PW and the P-type substrate PSUB. That is, the common body bias region JCB may be disposed to contact the P-well region PW of the first NMOS transistor NM1 and to contact the P-type substrate PSUB of the second NMOS transistor NM2.

The common body bias region JCB may be doped with P-type impurities whose concentration is higher than that of the P-well region PW.

According to one or more example embodiments, the common body bias region JCB may be formed to be spaced apart from the first NMOS transistor NM1 as much as a first distance D1. The separation of the first distance D1 may minimize electrical interference with the first NMOS transistor NM1. Also, the separation of the first distance D1 may minimize pattern interference in the process of patterning the first NMOS transistor NM1 and the common body bias region JCB. The common body bias region JCB may be formed to be spaced apart from the second NMOS transistor NM2 as much as a second distance D2. The separation of the second distance D2 may minimize electrical interference with the second NMOS transistor NM2. Also, the separation of the second distance D2 may minimize pattern interference in the process of patterning the second NMOS transistor NM2 and the common body bias region JCB.

According to one or more example embodiments, the first distance D1 and the second distance D2 may be identical. According to one or more example embodiments, the first distance D1 and the second distance D2, which are lengths for minimizing the electrical interference and the pattern interference with regard to the first NMOS transistor NM1 and the second NMOS transistor NM2, respectively, may be different depending on characteristics of the first NMOS transistor NM1 and the second NMOS transistor NM2. As an example, according to one or more example embodiments the first NMOS transistor NM1 is a low-voltage transistor and the second NMOS transistor NM2 is a high-voltage transistor, and, therefore, the second distance D2 may be greater than the first distance D1.

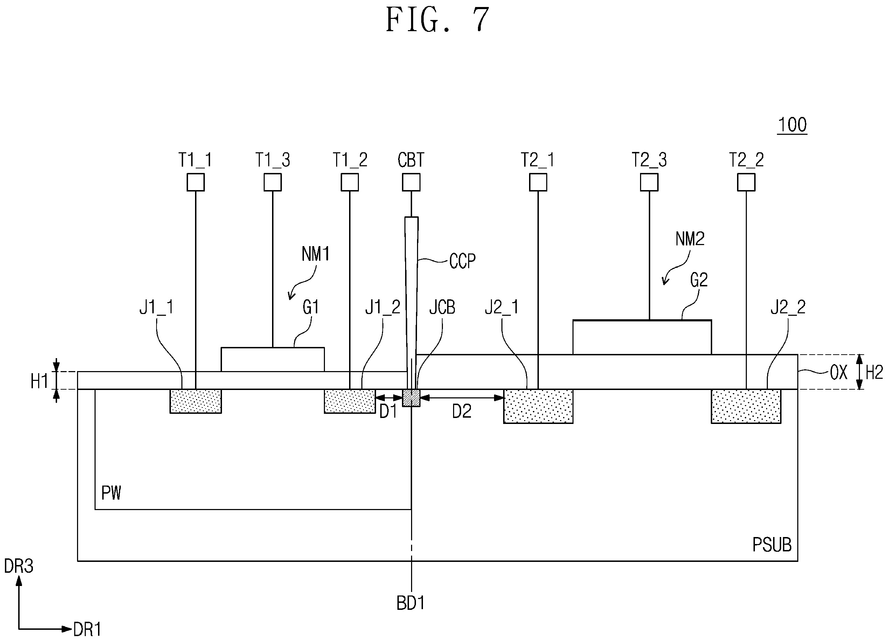

FIG. 7 is a cross-sectional view of a semiconductor device according to one or more example embodiments. Referring to FIG. 7, a portion of an oxide layer OX, on which the first NMOS transistor NM1 is formed, may be of a first height H1, and a portion of the oxide layer OX, on which the second NMOS transistor NM2 is formed, may be of a second height H2. There is a boundary BD1 between the portions of the oxide layers with heights H1 and H2. According to one or more example embodiments, the first height H1 may be different from the second height H2.

The first height H1 and the second height H2 may be different depending on characteristics of the first NMOS transistor NM1 and the second NMOS transistor NM2.

As an example, when the first NMOS transistor NM1 is a low-voltage transistor and the second NMOS transistor NM2 is a high-voltage transistor, a relatively low voltage may be applied to the first gate G1, and thus, the first height H1 of the oxide layer OX may be relatively small. According to one or more example embodiments, a relatively high voltage may be applied to the second gate G2. Accordingly, to endure a high voltage applied to the second gate G2, the second portion of the oxide layer OX may be formed to have the second height H2 greater than the first height H1.

The first boundary BD1 may be defined vertically at a boundary of the P-well region PW and the P-type substrate PSUB. According to one or more example embodiments, the common body bias region JCB is formed to contact both the P-well region PW and the P-type substrate PSUB. The common body bias region JCB and a common body bias contact plug CCP may be formed on the first boundary BD1. That is, the common body bias contact plug CCP may be formed at a boundary where a difference between the first height H1 and the second height H2 occurs, that is, a step occurs at the oxide layer OX.

The ground voltage applied to the common body bias terminal CBT may be transferred to one common body bias region JCB, which the first NMOS transistor NM1 and the second NMOS transistor NM2 share, through the common body bias contact plug CCP, so as to be provided to the first NMOS transistor NM1 and the second NMOS transistor NM2, respectively.

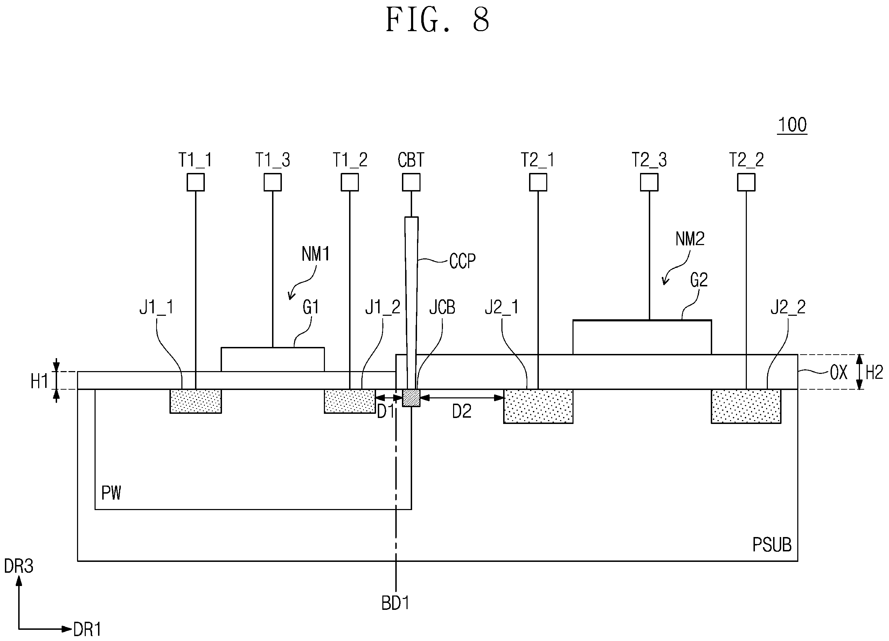

FIG. 8 is a cross-sectional view of a semiconductor device according to one or more example embodiments. Referring to FIG. 8, a first boundary BD1 may be located in the P-well region PW, and the common body bias contact plug CCP may be formed at a portion of an oxide layer, which has the second height H2.

A step-free portion of the oxide layer OX may be used to form the common body bias contact plug CCP stably in the process of manufacturing the semiconductor device 100. That is, the oxide layer OX may be formed such that the first boundary BD1 where the oxide layer OX has a step (i.e., a height difference) is located in the P-well region PW where the first NMOS transistor NM1 is formed. That is, the first boundary BD1 is located between the second active region J1_2 of the first NMOS transistor NM1 and the common body bias region JCB. According to one or more example embodiments, an even oxide layer with a uniform thickness and having the second height H2, when viewed in the third direction DR3, may be formed on the common body bias region JCB.

The common body bias contact plug CCP may be formed at the even portion of the oxide layer OX with the second height H2. Because a risk factor due to the step in the oxide layer OX is removed in the process of manufacturing the semiconductor device 100, the common body bias contact plug CCP may be stably formed to contact the common body bias region JCB.

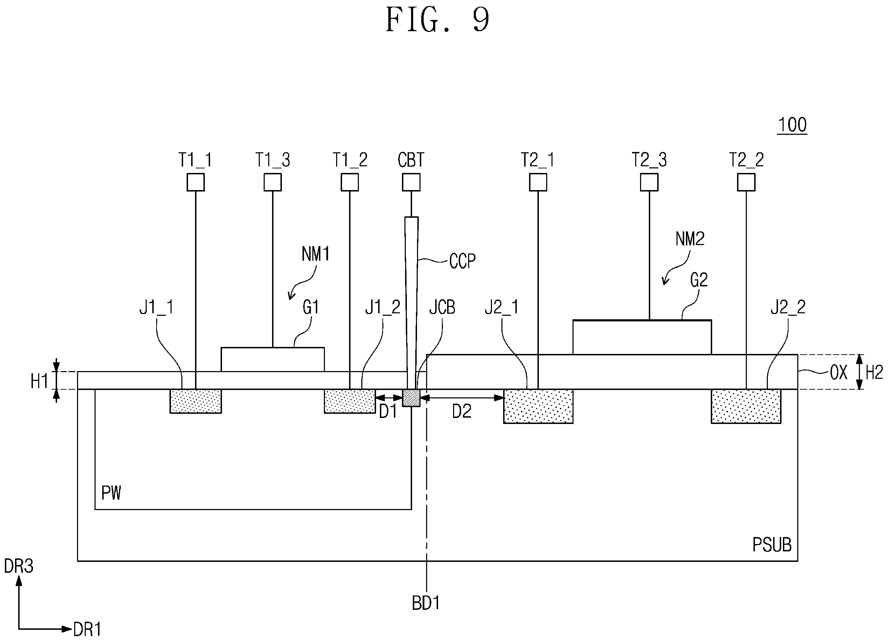

FIG. 9 is a cross-sectional view of a semiconductor device according to one or more example embodiments. Referring to FIG. 9, the first boundary BD1 may be located outside the P-well region PW. That is, the first boundary BD1 may be located in the P-type substrate PSUB, and the common body bias contact plug CCP may be formed at a portion of the oxide layer OX, which has the first height H1.

As in the above description, according to one or more example embodiments, a step-free portion of the oxide layer OX may be used to form the common body bias contact plug CCP stably. That is, the oxide layer OX may be formed such that the first boundary BD1 where the oxide layer OX has a step is located outside the P-well region PW. That is, the first boundary BD1 may be located in the P-type substrate PSUB between the common body bias region JCB and the first active region J2_1 of the second NMOS transistor NM2. According to one or more example embodiments, an even oxide layer with a uniform thickness having the first height H1, when viewed in the third direction DR3, may be formed on the common body bias region JCB.

The common body bias contact plug CCP may be formed on the even oxide layer OX with the first height H1. Because a risk factor due to the step in the oxide layer OX is removed in the process of manufacturing the semiconductor device 100, the common body bias contact plug CCP may be stably formed.

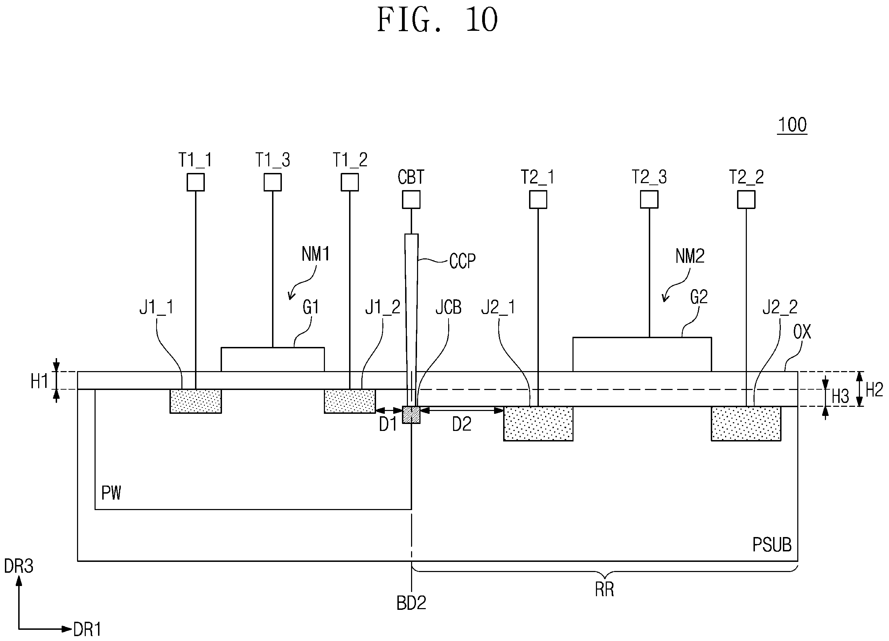

FIG. 10 is a cross-sectional view of a semiconductor device according to one or more example embodiments. Referring to FIG. 10, the second NMOS transistor NM2 may be disposed in a recess region RR, which is formed by etching the P-type substrate PSUB as much as a third height H3 based on a second boundary BD2. The surface of the oxide layer OX may be formed on a same plane. That is, the surface of the oxide layer OX may be even. The second boundary BD2, where a step occurs due to the etching of the P-type substrate PSUB may be located, may be defined by the P-well region PW and the P-type substrate PSUB that are in contact with each other in a vertical direction, and the common body bias contact plug CCP may be formed on the second boundary BD2.

When the first NMOS transistor NM1 is a low-voltage transistor and the second NMOS transistor NM2 is a high-voltage transistor, the oxide layer OX of the first NMOS transistor (NM1) side may be formed to have the first height H1, and the oxide layer OX of the second NMOS transistor (NM2) side may be formed to have the second height H2 greater than the first height H1. According to one or more example embodiments, a portion of the P-type substrate PSUB may be etched as much as the third height H3 corresponding to a difference between the first height H1 and the second height H2. The portion of the P-type substrate PSUB, which is etched as much as the third height H3, may be defined as the recess region RR.

Because the second NMOS transistor NM2 is disposed in the recess region RR, even though the surface of the oxide layer OX is formed on the same plane, the oxide layer OX formed on the first NMOS transistor (NM1) side may have the first height H1, and the oxide layer OX formed on the second NMOS transistor (NM2) side may have the second height H2.

According to one or more example embodiments, a mask that is used to dope the P-well region PW with P-type impurities may be identically used as a mask for etching the P-type substrate PSUB. The second boundary BD2, which is a boundary of the etched portion of the P-type substrate PSUB, may be located at the boundary between the P-well region PW and the P-type substrate PSUB. The common body bias contact plug CCP may be formed on the second boundary BD2. That is, the P-well region PW and the recess region RR may be formed by using one mask.

The second boundary BD2 for distinguishing the recess region RR may be defined vertically at the boundary of the P-well region PW and the P-type substrate PSUB. According to one or more example embodiments, the common body bias region JCB is formed to contact both the P-well region PW and the P-type substrate PSUB. The common body bias contact plug CCP may be formed at the boundary where a step of the P-type substrate PSUB occurs.

The ground voltage applied to the common body bias terminal CBT may be transferred to one common body bias region JCB, which the first NMOS transistor NM1 and the second NMOS transistor NM2 share, through the common body bias contact plug CCP, so as to be provided to the first NMOS transistor NM1 and the second NMOS transistor NM2, respectively.

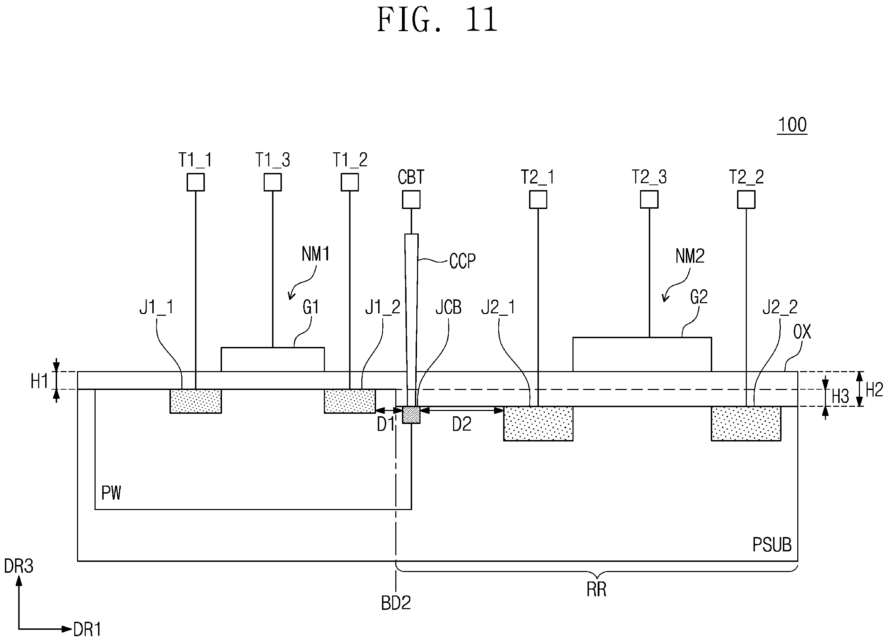

FIG. 11 is a cross-sectional view of a semiconductor device according to one or more example embodiments. Referring to FIG. 11, the second boundary BD2 may be located in the P-well region PW, and the common body bias contact plug CCP may be formed in the recess region RR.

A step-free portion of the P-type substrate PSUB may be used to form the common body bias contact plug CCP stably in the process of manufacturing the semiconductor device 100. The P-type substrate PSUB may be etched such that the second boundary BD2 where a step of the P-type substrate PSUB occurs as much as the third height H3 is located in the P-well region PW between the second active region J1_2 of the first NMOS transistor NM1 and the common body bias region JCB. That is, the common body bias region JCB may be formed in the recess region RR that is defined by etching the P-type substrate PSUB as much as the third height H3. The oxide layer OX of the second height H2 may be formed on the common body bias region JCB. Because the common body bias region JCB is formed in the recess region RR, the common body bias contact plug CCP may be stably formed in a region where the P-type substrate PSUB and the oxide layer OX have an even surface. As such, a risk factor due to a step between the P-type substrate PSUB and the oxide layer OX may be removed, and the common body bias contact plug CCP may be stably formed.

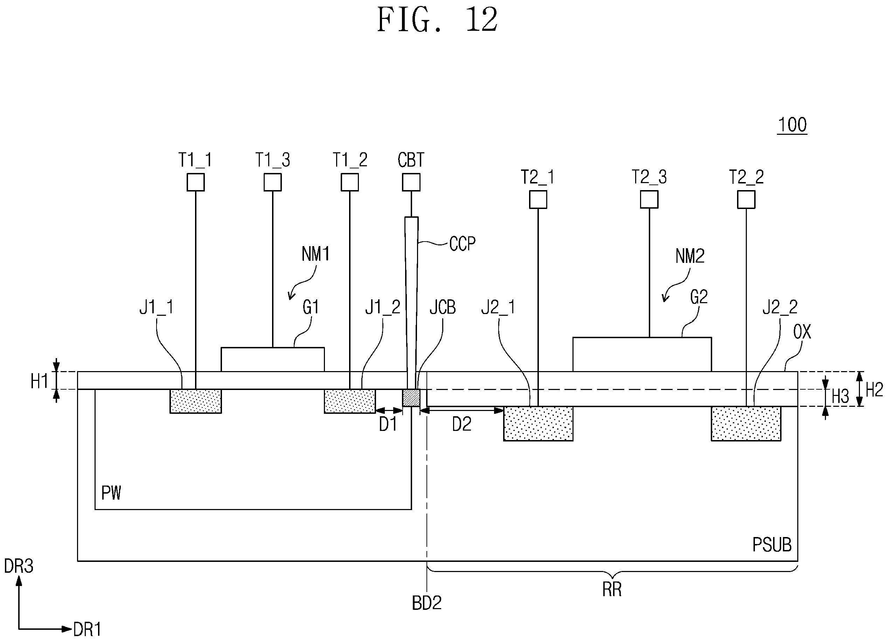

FIG. 12 is a cross-sectional view of a semiconductor device according to one or more example embodiments. Referring to FIG. 12, the second boundary BD2 may be located outside the P-well region PW. That is, the second boundary BD2 may be located in the P-type substrate PSUB, and the common body bias contact plug CCP may be formed outside the recess region RR.

As in the above description, according to one or more example embodiments, a step-free portion of the P-type substrate PSUB may be used to form the common body bias contact plug CCP stably. That is, the P-type substrate PSUB may be etched such that the second boundary BD2 where a step occurs as much as the third height H3 is located outside the P-well region PW. That is, the second boundary BD2 may be located in the P-type substrate PSUB between the common body bias region JCB and the first active region J2_1 of the second NMOS transistor NM2. The common body bias region JCB may be defined outside the recess region RR etched as much as the third height H3. The oxide layer of the first height H1 may be formed on the common body bias region JCB. Because the common body bias region JCB is formed outside the recess region RR, the common body bias contact plug CCP may be stably formed in a region where the P-type substrate PSUB and the oxide layer OX have an even surface. As such, a variable due to a step between the P-type substrate PSUB and the oxide layer OX may be removed, and the common body bias contact plug CCP may be stably formed.

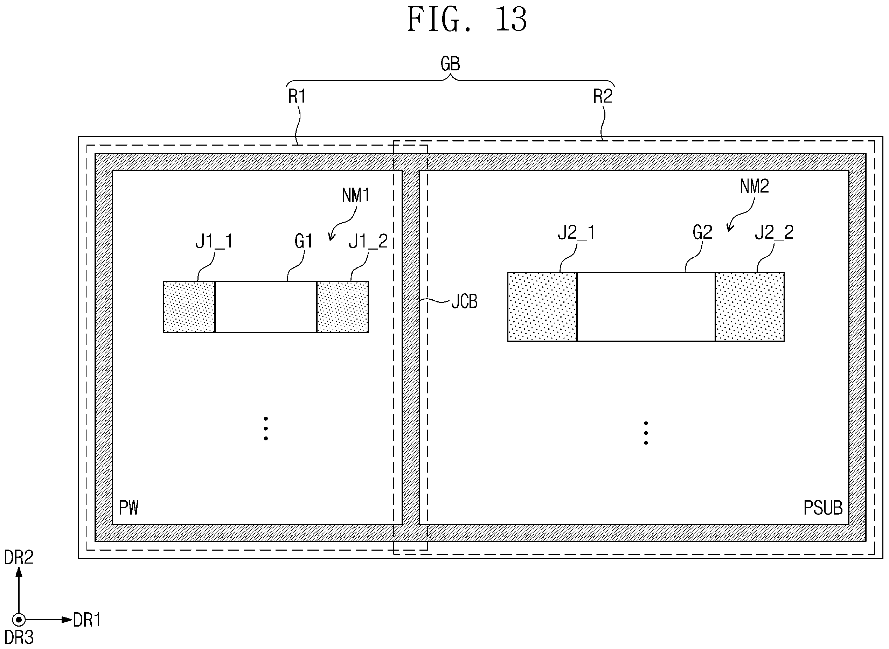

FIG. 13 is a plan view illustrating a guard band of a semiconductor device according to one or more example embodiments. Referring to FIG. 13, the common body bias region JCB may form a guard band GB.

The guard band GB may be formed in the P-type substrate PSUB in a surrounding shape such that the first NMOS transistor NM1 and the second NMOS transistor NM2 are electrically protected. The guard band GB may include a first portion R1, in which one or more first NMOS transistors NM1 are included, and a second portion R2, in which one or more second NMOS transistors NM2 are included. According to one or more example embodiments, the first portion R1 of the guard band GB may be formed to surround the P-well region PW. The first portion R1 and the second portion R2 of the guard band GB may share one common body bias region JCB. According to one or more example embodiments, the common body bias region JCB of the guard band GB may be formed at the boundary of the P-well region PW and the P-type substrate PSUB.

The guard band GB may refer to a region that is doped with P-type impurities whose concentration is higher than that of the P-well region PW. The ground voltage may be applied to the guard band GB through a contact plug. The body bias voltage may be provided to the first NMOS transistor NM1 and the second NMOS transistor NM2 through the guard band GB.

Compared to a structure of a guard band where an independent ring-shaped region including the first NMOS transistor NM1 and an independent ring-shaped region including the second NMOS transistor NM2 are separated from each other, the guard band GB according to one or more example embodiments may be implemented with the smaller area.

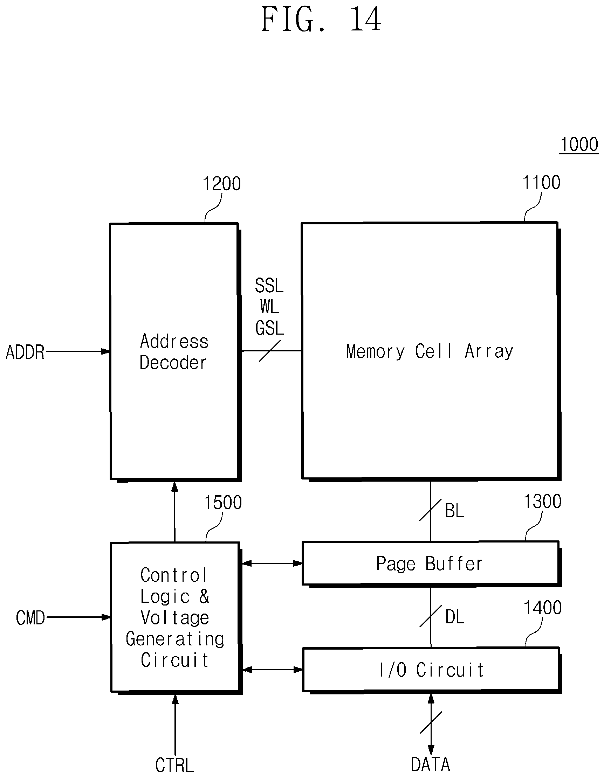

FIG. 14 is a block diagram indicating a memory device to which a semiconductor device according to one or more example embodiments is applied. Referring to FIG. 14, a memory device 1000 may include a memory cell array 1100, an address decoder 1200, a page buffer circuit 1300, an input/output circuit 1400, and a control logic and voltage generating circuit 1500.

In one or more example embodiments, the remaining components other than the memory cell array 1100, for example, the address decoder 1200, the page buffer circuit 1300, the input/output circuit 1400, and the control logic and voltage generating circuit 1500 may be included in a peripheral circuit. In one or more example embodiments, the memory device 1000 may have a cell on peripheral (COP) or complementary metal-oxide semiconductor (CMOS) under array (CUA) structure in which the memory cell array 1100, a memory cell structure, or memory cells, are stacked on the peripheral circuit (or a peripheral circuit region).

The memory cell array 1100 may include a plurality of memory blocks. Each of the plurality of memory blocks may include a plurality of cell strings, and each of the plurality of cell strings may be connected to a plurality of bit lines BL. Each of the plurality of cell strings may include a plurality of cell transistors connected in series. The plurality of cell transistors may be connected to string selection lines SSL, word lines WL, and ground selection lines GSL.

The address decoder 1200 may be connected to the memory cell array 1100 through the string selection lines SSL, the word lines WL, and the ground selection lines GSL. The address decoder 1200 may receive an address ADDR from an external device (e.g., a memory controller) and may decode the received address ADDR. The address decoder 1200 may control or drive voltages of the string selection lines SSL, the word lines WL, and the ground selection lines GSL based on the decoded address ADDR.

The page buffer circuit 1300 may be connected to the memory cell array 1100 through the bit lines BL. The page buffer circuit 1300 may read data stored in the memory cell array 1100 by sensing voltage changes of the bit line BL. The page buffer circuit 1300 may provide the read data to the input/output circuit 1400. The page buffer circuit 1300 may be configured to temporarily store data "DATA" received through the input/output circuit 1400. The page buffer circuit 1300 may control or drive the bit lines BL based on the temporarily stored data "DATA".

The input/output circuit 1400 may exchange the data "DATA" with the external device (e.g., a memory controller). The input/output circuit 1400 may provide the data "DATA" received from the external device to the page buffer circuit 1300 or may provide the data "DATA" received from the page buffer circuit 1300 to the external device.

The control logic and voltage generating circuit 1500 (hereinafter referred to as a "control logic circuit") may be configured to generate the following voltages necessary for the memory device 1000 to operate: a plurality of program voltages, a plurality of program verify voltages, a plurality of pass voltages, a plurality of read voltages, and a plurality of erase voltages.

The control logic circuit 1500 may control the operation of the memory device 1000 in response to a command CMD and a control signal CTRL from the external device. For example, the control logic circuit 1500 may control the address decoder 1200, the page buffer circuit 1300, and the input/output circuit 1400 in response to the command CMD such that an operation (e.g., a program operation, a read operation, or an erase operation) corresponding to the command CMD is performed.

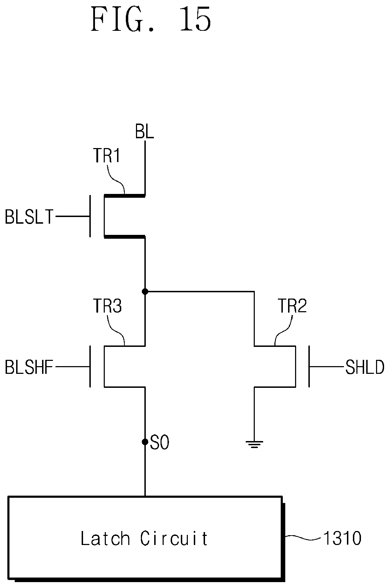

FIG. 15 is a diagram illustrating a portion of a page buffer circuit of FIG. 14 according to one or more example embodiments. Referring to FIG. 15, the page buffer circuit 1300 may be connected to a memory cell of a cell string through the bit line BL.

The page buffer circuit 1300 may include a first transistor TR1, a second transistor TR2, and a third transistor TR3. The first transistor TR1 may select the bit line BL in response to a bit line selection signal BLSLT. The third transistor TR3 may discharge a page buffer page in response to a shield signal SHLD.

A latch circuit 1310 may detect a voltage level of the sensing node SO. The latch circuit 1310 may latch data based on the detected voltage level of the sensing node SO.

The first transistor TR1 may be a high-voltage transistor, and the bit line selection signal BLSLT whose voltage level is higher than or equal to that of the power supply voltage VDD may be applied to the gate of the first transistor TR1. According to one or more example embodiments, the first transistor TR1 may correspond to the second NMOS transistor NM2 of FIG. 4.

According to one or more example embodiments, the second transistor TR2 may be a low-voltage transistor, and the shield signal SHLD may be applied to the second transistor TR2. The second transistor TR2 may correspond to the first NMOS transistor NM1 of FIG. 4.

The first transistor TR1 and the second transistor TR2 may be formed on the substrate to share a common body bias region, as illustrated in FIGS. 4, 5, 6, 7, 8, 9, 10, 11, 12 and 13.

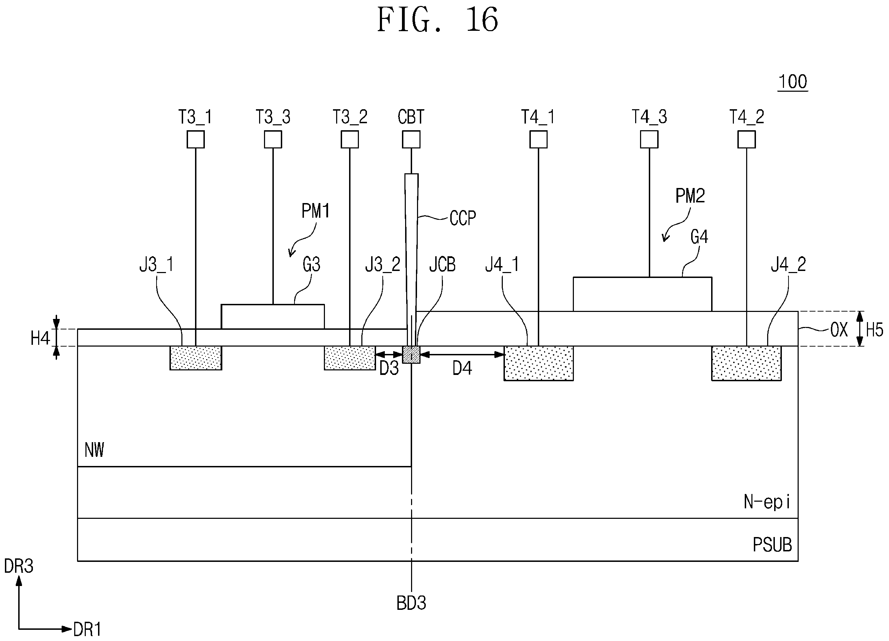

FIG. 16 is a cross-sectional view of a semiconductor device according to one or more example embodiments. Referring to FIG. 16, the semiconductor device 100 may include a first P-type metal-oxide-semiconductor (PMOS) transistor PM1, a second PMOS transistor PM2, and one common body bias region JCB. The first PMOS transistor PM1 and the second PMOS transistor PM2 may be formed on an N-type epitaxial layer N-epi corresponding to a substrate. The N-type epitaxial layer N-epi may be formed on a plane defined by the first direction DR1 and the second direction DR2.

The first PMOS transistor PM1 may include a first active region J3_1, a second active region J3_2, and a third gate G3. The first active region J3_1 and the second active region J3_2 of the first PMOS transistor PM1 may be regions doped with P-type impurities. The first active region J3_1 and the second active region J3_2 of the first PMOS transistor PM1 may be formed in an N-well region NW on the N-type epitaxial layer N-epi. The N-well region NW may be a region doped with N-type impurities whose concentration is relatively high compared to the N-type epitaxial layer N-epi. The oxide layer OX may be formed on the first active region J3_1 and the second active region J3_2 of the first PMOS transistor PM1. The third gate G3 may be formed on the oxide layer OX. In the first PMOS transistor PM1, the first active region J3_1 may be electrically connected to a first terminal T3_1, the second active region J3_2 may be electrically connected to a second terminal T3_2, and the third gate G3 may be electrically connected to a third terminal T3_3. In the first PMOS transistor PM1, each of the electrical connection of the first active region J3_1 and the first terminal T3_1, the electrical connection of the second active region J3_2 and the second terminal T3_2, and the electrical connection of the second gate G3 and the third terminal T3_3 may be implemented through a contact plug formed along the third direction DR3.

The second PMOS transistor PM2 may include a first active region J4_1, a second active region J4_2, and a fourth gate G4. The first active region J4_1 and the second active region J4_2 of the second PMOS transistor PM2 may be regions doped with P-type impurities. The first active region J4_1 and the second active region J4_2 of the second PMOS transistor PM2 may be formed on the N-type epitaxial layer N-epi. The oxide layer OX may be formed on the first active region J4_1 and the second active region J4_2 of the second PMOS transistor PM2. The fourth gate G4 may be formed on the oxide layer OX. In the second PMOS transistor PM2, the first active region J4_1 may be electrically connected to a first terminal T4_1, the second active region J4_2 may be electrically connected to a second terminal T4_2, and the fourth gate G4 may be electrically connected to a third terminal T4_3. In the second PMOS transistor PM2, each of the electrical connection of the first active region J4_1 and the first terminal T4_1, the electrical connection of the second active region J4_2 and the second terminal T4_2, and the electrical connection of the fourth gate G4 and the third terminal T4_3 may be implemented through a contact plug formed along the third direction DR3.

According to one or more example embodiments, the common body bias region JCB may be disposed between the first PMOS transistor PM1 and the second PMOS transistor PM2 and may be formed to contact both the N-well region NW and the N-type epitaxial layer N-epi. That is, the common body bias region JCB may be disposed to contact the N-well region NW of the first PMOS transistor PM1 and to contact the N-type epitaxial layer N-epi of the second PMOS transistor PM2.

The common body bias region JCB may be doped with N-type impurities whose concentration is higher than that of the N-well region NW.

According to one or more example embodiments, the common body bias region JCB may be formed to be spaced apart from the first PMOS transistor PM1 as much as a third distance D3. The separation of the third distance D3 may minimize electrical interference with the first PMOS transistor PM1. Also, the separation of the third distance D3 may minimize pattern interference between the first PMOS transistor PM1 and the common body bias region JCB. The common body bias region JCB may be formed to be spaced apart from the second PMOS transistor PM2 as much as a fourth distance D4. The separation of the fourth distance D4 may minimize electrical interference with the second PMOS transistor PM2. Also, the separation of the fourth distance D4 may minimize pattern interference between the second PMOS transistor PM2 and the common body bias region JCB.

According to one or more example embodiments, the third distance D3 and the fourth distance D4 may be identical. According to one or more example embodiments, the third distance D3 and the fourth distance D4 may be different depending on characteristics of the first PMOS transistor PM1 and the second PMOS transistor PM2. As an example, when the first PMOS transistor PM1 is a low-voltage transistor and the second PMOS transistor PM2 is a high-voltage transistor, the third distance D3 may be smaller than the fourth distance D4.

According to one or more example embodiments, based on a third boundary BD3 between the first PMOS transistor PM1 and the second PMOS transistor PM2, a portion of the oxide layer OX on the first PMOS transistor (PM1) side may have a fourth height H4, and a portion of the oxide layer OX on the second PMOS transistor (PM2) side may have a fifth height H5. According to one or more example embodiments, the fourth height H4 and the fifth height H5 may be different depending on the characteristics of the first PMOS transistor PM1 and the second PMOS transistor PM2.

The third boundary BD3 may be defined vertically at a boundary of the N-well region NW and the N-type epitaxial layer N-epi. According to one or more example embodiments, the common body bias region JCB is formed to contact both the N-well region NW and the N-type epitaxial layer N-epi. The common body bias region JCB and the common body bias contact plug CCP may be formed on the third boundary BD3. That is, the common body bias contact plug CCP may be formed at a boundary where a difference between the fourth height H4 and the fifth height H5, that is, a step occurs at the oxide layer OX.

The ground voltage applied to the common body bias terminal CBT may be transferred to one common body bias region JCB, which the first PMOS transistor PM1 and the second PMOS transistor PM2 share, through the common body bias contact plug CCP, so as to be provided to the first PMOS transistor PM1 and the second PMOS transistor PM2, respectively.

According to one or more example embodiments, an architecture corresponding to the architecture shown in FIGS. 5, 6, 8, 9, 10, 11, 12 and 13 could alternatively be applied to the semiconductor device of Fig. 16.

The above description relates to one or more example embodiments of the semiconductor device 100, and, according to one or more example embodiments, the semiconductor device 100 may be modified and carried out with reference to FIGS. 5, 6, 7, 8, 9, 10, 11 and 12.

According to one or more example embodiments, a semiconductor device with the reduced area and reduced costs is provided.

Example embodiments may include some or all of the features in the following numbered clauses:
1. A semiconductor device comprising:
   a substrate comprising a P-well region;
   a first N-type metal oxide semiconductor (NMOS) transistor provided on the P-well region;
   a second NMOS transistor provided on the substrate; and
   a common body bias region provided between the first NMOS transistor and the second NMOS transistor and contacting both the P-well region and the substrate,
   wherein the common body bias region is configured to provide a bias voltage to the first NMOS transistor and the second NMOS transistor.
2. The semiconductor device of clause 1, further comprising:
   a common body bias contact plug which contacts the common body bias region.
3. The semiconductor device of clause 2, further comprising:
   an oxide layer provided on the substrate,
   wherein the oxide layer comprises a first portion and a second portion separated by a first boundary,
   wherein the first portion corresponds to the first NMOS transistor and has a first height, and
   wherein the second portion corresponds to the second NMOS transistor and has a second height.
4. The semiconductor device of clause 3, wherein the first boundary extends vertically through a point where the P-well region and the substrate contact each other, and
   wherein the common body bias contact plug is provided on the first boundary.
5. The semiconductor device of clause 3, wherein the first boundary is located between the first NMOS transistor and the common body bias region, and
   wherein the common body bias contact plug is provided at a portion of the oxide layer having the second height.
6. The semiconductor device of clause 3, wherein the first boundary is located between the common body bias region and the second NMOS transistor, and
   wherein the common body bias contact plug is provided at a portion of the oxide layer having the first height.
7. The semiconductor device of clause 3, wherein the second NMOS transistor is provided in a recess region provided by etching the substrate to a third height from a second boundary.
8. The semiconductor device of clause 7, wherein a topmost surface of the oxide layer is planar.
9. The semiconductor device of clause 7, wherein the second boundary extends vertically through a point where the P-well region and the substrate contact each other, and
   wherein the common body bias contact plug is provided on the second boundary.
10. The semiconductor device of clause 7, wherein the second boundary extends between the first NMOS transistor and the common body bias region, and
   wherein the common body bias contact plug is provided in the recess region.
11. The semiconductor device of clause 7, wherein the second boundary extends between the common body bias region and the second NMOS transistor, and
   wherein the common body bias contact plug is provided outside the recess region.
12. The semiconductor device of any of the preceding clauses, wherein the common body bias region comprises a guard band.
13. The semiconductor device of clause 12, wherein the guard band comprises:
   a first portion provided around the first NMOS transistor; and
   a second portion provided around the second NMOS transistor, and wherein the first portion and the second portion contact the common body bias region.

While example embodiments have been particularly shown and described, it will be apparent to those of ordinary skill in the art that various changes and modifications in form and details may be made thereto without departing from the scope of the present disclosure as set forth in the following claims.

## Claims

1. A semiconductor device comprising:
a substrate having a first conductivity type;
a well region having the first conductivity type and provided on the substrate;
a first metal oxide semiconductor, MOS, transistor provided on the well region and including a first active region having a second conductivity type;
a second MOS transistor provided on the substrate and including a second active region having the second conductivity type; and
a common body bias region provided between the first MOS transistor and the second MOS transistor and contacting both the well region and the substrate,
wherein the first MOS transistor and the second MOS transistor are electrically connected to the common body bias region, and
wherein the common body bias region is configured to provide a bias voltage to the first MOS transistor and the second MOS transistor.

2. The semiconductor device of claim 1, wherein:
the first conductivity type is P-type,
the second conductivity type is N-type,
the first MOS transistor is an N-type metal oxide semiconductor, NMOS transistor, and
the second MOS transistor is an NMOS transistor.

3. The semiconductor device of claim 1 or 2, further comprising:
a common body bias contact plug which contacts the common body bias region.

4. The semiconductor device of claim 3, further comprising:
an oxide layer provided on the substrate,
wherein the oxide layer comprises a first portion and a second portion separated by a first boundary,
wherein the first portion corresponds to the first MOS transistor and has a first height, and
wherein the second portion corresponds to the second MOS transistor and has a second height.

5. The semiconductor device of claim 4, wherein the first boundary extends vertically through a point where the well region and the substrate contact each other, and
wherein the common body bias contact plug is provided on the first boundary.

6. The semiconductor device of claim 4, wherein the first boundary is located between the first MOS transistor and the common body bias region, and
wherein the common body bias contact plug is provided at a portion of the oxide layer having the second height.

7. The semiconductor device of claim 4, wherein the first boundary is located between the common body bias region and the second MOS transistor, and
wherein the common body bias contact plug is provided at a portion of the oxide layer having the first height.

8. The semiconductor device of claim 4, wherein the second MOS transistor is provided in a recess region provided by etching the substrate to a third height from a second boundary.

9. The semiconductor device of claim 8, wherein a topmost surface of the oxide layer is planar.

10. The semiconductor device of claim 8, wherein the second boundary extends vertically through a point where the well region and the substrate contact each other, and
wherein the common body bias contact plug is provided on the second boundary.

11. The semiconductor device of claim 8, wherein the second boundary extends between the first MOS transistor and the common body bias region, and
wherein the common body bias contact plug is provided in the recess region.

12. The semiconductor device of claim 8, wherein the second boundary extends between the common body bias region and the second MOS transistor, and
wherein the common body bias contact plug is provided outside the recess region.

13. The semiconductor device of any preceding claim, wherein the common body bias region comprises a guard band.

14. The semiconductor device of claim 13, wherein the guard band comprises:
a first portion provided around the first MOS transistor; and
a second portion provided around the second MOS transistor, and
wherein the first portion and the second portion contact the common body bias region.

15. A semiconductor device comprising:
a substrate comprising:
a P-well region comprising:
a first active region;
a second active region; and
a first gate provided between the first active region and the second active region;
a substrate region comprising:
a third active region;
a fourth active region; and
a second gate provided between the third active region and the fourth active region; and
a common body bias region contacting the substrate region and the P-well region,
wherein the common body bias region is configured to provide a bias voltage to at least one of the first active region and second active region, and to at least one of the third active region and the fourth active region.
